# EUROPÄISCHE PATENTSCHRIFT

(11) **EP 2 286 472 B1**
(45) Veröffentlichungstag und Bekanntmachung des Hinweises auf die Patenterteilung: **13.11.2013**
(21) Anmeldenummer: 09757516.1
(22) Anmeldetag: 02.06.2009
(51) Int. Cl.: H01L 41/12, H01L 41/20, H01L 41/47, F03G 7/06

(54) **BAUELEMENT AUS EINEM FERROMAGNETISCHEN FORMGEDÄCHTNISMATERIAL UND DESSSEN VERWENDUNG**
CONSTRUCTION ELEMENT MADE OF A FERROMAGNETIC SHAPE MEMORY MATERIAL AND USE THEREOF
COMPOSANT EN MATÉRIAU FERROMAGNÉTIQUE À MÉMOIRE DE FORME ET SON UTILISATION

(30) Priorität: 02.06.2008 DE 102008026297
(43) Veröffentlichungstag der Anmeldung: 23.02.2011
(73) Patentinhaber: Leibniz-Institut für Festkörper- und Werkstoffforschung Dresden e.V., 01069 Dresden (DE)
(72) Erfinder: FÄHLER, Sebastian, 01099 Dresden (DE); THOMAS, Michael, 01309 Dresden (DE); HECZKO, Oleg, 16200 Prague (DE); BUSCHBECK, Jörg, 01069 Dresden (DE); Mc CORD, Jeffrey, 01187 Dresden (DE)
(74) Vertreter: Rauschenbach, Marion
(86) Internationale Anmeldenummer: PCT/EP2009/056739
(87) Internationale Veröffentlichungsnummer: WO 2009/147135

(56) Entgegenhaltungen:
- EP-A- 0 866 142
- EP-A- 1 630 416
- WO-A-02/064847
- CN-A- 1 501 410
- CN-A- 101 078 082
- US-A1- 2006 162 331
- LIU Z H ET AL: "Martensitic transformation and shape memory effect in ferromagnetic Heusler alloy Ni2FeGa" APPLIED PHYSICS LETTERS, AIP, AMERICAN INSTITUTE OF PHYSICS, MELVILLE, NY, US, Bd. 82, Nr. 3, 20. Januar 2003 (2003-01-20), Seiten 424-426, XP012034592 ISSN: 0003-6951
- ZHENG H X ET AL: "Martensitic transformation of Ni-Fe-Ga-(Co, Ag) magnetic shape memory alloys" JOURNAL OF ALLOYS AND COMPOUNDS, ELSEVIER SEQUOIA, LAUSANNE, CH, Bd. 387, Nr. 1-2, 25. Januar 2005 (2005-01-25), Seiten 265-268, XP025330067 ISSN: 0925-8388 [gefunden am 2005-01-25]

## Beschreibung

Die Erfindung bezieht sich auf das Gebiet der Materialwissenschaften und betrifft ein Bauelement aus einem ferromagnetischen Formgedächtnismaterial, welches beispielsweise für Mikrobauteile, Mikrosensoren und Mikroaktoren zur Anwendung kommen kann.

Seit der Entdeckung magnetischer Formgedächtnislegierungen [Ullakko, K. et al.: Appl. Phys. Lett. 69 (13), 1966 (1996)] konnten große Dehnungen von bis zu 10 % in Ni-Mn-Ga Einkristallen in einem Magnetfeld durch Umorientierung der Kristallstruktur erreicht werden [Sozinov, A., et al: Appl. Phys. Lett. 80 (10), 1746 (2002)]. Die dafür notwendige magnetische Feldstärke beträgt weniger als 1 T.
Diese Entdeckung führte zur intensiven Erforschung neuer Zusammensetzungen von Ni-Mn-Ga [Takeuchi, I. et al.: Nature Materials 2, 180 (2003)] sowie auch anderer neuer Materialien, wie Ni-Mn-In [Lavrov, A., et al: Nature 418 (6896), 385 (2002); Kainuma, R. et al.: Nature 439, 957 (2006)]. Neue Präparationswege, wie Schaum [Boonyongmaneerat, Y., et al: Phys. Rev. Lett. 99, 247201 (2007)] oder Komposite [Scheerbaum, N., et al: Acta Mat. 55, 2707 (2007)] wurden entwickelt. Weiterhin wurden neue Anwendungsmöglichkeiten, wie die magnetische Kühlung [Krenke, T. et al: Nature Mat. 4, 450 (2005)], erforscht.
Die bedeutendsten magnetischen Formgedächtnis-Materialien sind Ni-Mn-Ga- und Fe-Pd-Legierungen. Bei Ni-Mn-Ga wird eine Verkürzung des Materials entlang der Richtung des angelegten Magnetfeldes erreicht, während Fe-Pd unter gleichen Bedingungen eine Ausdehnung zeigt. Die maximale Dehnung wird jedoch nur in Einkristallen erreicht.

Magnetische Formgedächtnislegierungen sind zunächst auch konventionelle thermische Formgedächtnislegierungen [Otsuka, K., Wayman, C. M. (ed.) Shape Memory Materials (Cambridge University Press, Cambridge 1998)].
Diese Materialien haben einen martensitischen Übergang von einer kubischen Hochtemperaturphase, dem Austenit, zu einer niedrig-symmetrischen Niedrigtemperaturphase, dem Martensit [Bhattacharya, K. et al: Nature 428, 55 (2004)]. Die Martensitphase kann z. B. eine tetragonale Einheitszelle mit zwei identischen langen a-Achsen und einer kurzen c-Achse besitzen. Durch die Phasenumwandlung sind verschiedene kristallografisch wohldefinierte Orientierungen der martensitischen Einheitszelle möglich und damit entsteht eine charakteristische martensitische Mikrostruktur, bei der Varianten verschiedener kristallografischer Orientierungen durch Zwillingsgrenzen miteinander verbunden sind. Formgedächtnislegierungen, die einen reversiblen Martensitübergang aufweisen, können leicht verformbar sein. So wachsen bei Anlegen einer mechanischen Druck-Spannung Varianten mit der kurzen kristallografischen Achse parallel zur Spannungs-Achse auf Kosten der Varianten anderer Orientierung. Bei Materialien mit einem reversiblen martensitischen Übergang stellt das Aufheizen in die Austenitphase die ursprüngliche Form wieder her, da in der kubischen Phase alle Achsen der Einheitszelle identisch sind. Bei mehreren Durchläufen unter Ausübung von mechanischen Druck-Spannungen und Erhitzen können Defekte in der Mikrostruktur entstehen, die als Kristallisationskeime bei der Martensitbildung wirken. Das Gefüge kann sich so an die ungleiche Verteilung der Varianten erinnern und damit entsteht der Formgedächtniseffekt. In diesem sogenannten thermischen "Zwei-Wege Formgedächtniseffekt" wird die Temperatur als Kontrollparameter genutzt.

Martensitische und ferromagnetische Materialien haben gemeinsame Eigenschaften. So besitzen beide Materialklassen jeweils eine charakteristische Ordnungstemperatur. Unterhalb der martensitischen Übergangstemperatur wird eine parallele Ausrichtung benachbarter martensitischer Einheitszellen begünstigt, ähnlich einer parallelen Ausrichtung von magnetischen Momenten unterhalb der CurieTemperatur. Magnetische Formgedächtnislegierungen besitzen daher zwei sogenannte "ferroische" Eigenschaften, sie sind martensitisch und ferromagnetisch. Verschiedene Kombinationen dieser ferroischen Eigenschaften können für Aktormodi genutzt werden.
Der erste Aktormodus basiert auf der Kopplung zwischen Kristallstruktur und der spontanen Magnetisierung. Im Magnetfeld wird die Phase mit dem höheren magnetischen Moment energetisch bevorzugt, was eine Verschiebung der martensitischen Übergangstemperatur *T_{M}* erlaubt [Vasil'ev, A. N. et al: Phys. Usp. 46 (6), 559 (2003); Cherechukin, A. A. et al. Phys. Lett. A 291, 175 (2001)]. Wie auch bei gut trainierten thermischen Formgedächtnislegierungen kann dieser "Magnetisch Induzierte Martensit" (MIM) als Aktor in Nähe der martensitischen Übergangstemperatur betrieben werden [Kainuma, R. et al. Nature 439, 957 (2006)]. Der zweite Aktormodus wurde in Einkristallen innerhalb der Martensitphase beobachtet. Dabei wird die sogenannte "Magnetisch Induzierte Reorientierung" (MIR) genutzt, auch magnetischer Formgedächtniseffekt genannt. Bei MIR muss die Differenz in der Gesamtenergie, bei Ausrichtung der Magnetisierung in unterschiedliche Kristallrichtungen, betrachtet werden. Dies wird mit der magnetokristallinen Anisotropie-Energie beschrieben [O'Handley, R. C. Modern Magnetic Materials (John Wiley & Sons, Inc, New York, 2000)]. Die Kopplung zwischen kristallografischer Orientierung und der bevorzugten Magnetisierungsrichtung ermöglicht eine Änderung der martensitischen Mikrostruktur. So kann ein Magnetfeld dazu genutzt werden die Zwillingsgrenzen so zu bewegen, dass der Anteil der martensitischen Varianten, die ihre energetisch günstige leichte Magnetisierungsachse parallel zum äußeren Feld haben, zunimmt. Da die Gitterabstände der martensitischen Einheitszelle stark unterschiedlich sind, führt diese Reorientierung zu einer erheblichen Längenänderung. MIR ermöglicht reversible, relative Längenänderungen von bis zu 10% [A. Sozinov, u.a., Appl. Phys. Letters, Vol. 80, 1746ff (2002)]. Dadurch ergeben sich Vorteile für die Anwendung magnetischer Formgedächtnis-Materialien gegenüber den üblichen piezo- und magnetostriktiven Materialien. Als Kontrollparameter wird hier ein äußeres Magnetfeld verwendet. MIR selbst ist in WO 09808261 und WO 9703472 beschrieben worden. Die Herstellung und Anwendung von Magnetfeld- und Dehnungssensoren auf Basis von MIR wird in WO 03078922 beschrieben.
Aktoren, die das Prinzip von MIR nutzen, sind in US 6,515,382 A1 beschrieben. Darin ist auch ein Ventil angegeben, in welchem ein dünnes, magnetisches Formgedächtnis-Element als aktives Element verwendet wird (Abb.30-32).
Einen weiteren Ansatz, thermisch kontrollierte Mikroaktoren aus magnetischen Formgedächtnislegierungen aufzubauen, beschreibt Kohl et al. [US 7,142,341 A1]. Hier wird das Aktorelement über die Curietemperatur geheizt, so dass keine attraktive Anziehung mehr zu einem zusätzlichen Permanentmagneten besteht. Der entscheidende Vorteil des hier beantragten Ansatzes liegt darin, dass dieser zusätzliche Permanentmagnet zur Erzeugung eines externen Feldes nicht mehr benötigt wird. Weitere Bauelemente sind aus EP 1 630 416 A1 und US 2006/0162331 A1 bekannt.

Dünne, magnetische Formgedächtnisschichten sind von besonderem Interesse für Mikroaktoranwendungen, da aufgrund der großen relativen Dehnung die Komplexität zusätzlicher Hebel und zusätzliche mechanische Bauelemente vermieden werden können.
Epitaktische Schichten werden als am vielversprechendsten betrachtet, da die größten Dehnungen bis jetzt nur in massiven Einkristallen erreicht wurden [Dong, J., et al: Appl. Phys. Lett. 75 (10), 1443 (1999); Jakob, G. & Elmers, H. J.: J. Magn. Magn. Mater. 310 (2), 2779 (2007); Jakob, G., et al: Phys. Rev. B 76 (17), 174407 (2007); Buschbeck, J., et al: Phys. Rev. B 76, 205421(2007)].
Es wurde auch über MIR in orthorhombischen, epitaktischen Ni-Mn-Ga Schichten deponiert auf MgO(001) [Thomas, M. et al: New J. Phys. 10, 023040 (2008)] und SrTiO₃(100) [Heczko, O., et al: Appl. Phys. Lett. 92, 072502 (2008)] berichtet. Eine Reorientierung wurde beobachtet, obwohl eine makroskopische Ausdehnung der Schicht durch das Substrat behindert wurde. Eine geringe Spannung in der Höhe einiger MPa führt zur Blockierung von MIR [Murray, S. J., et al: J. Appl. Phys. 89 (2), 1295 (2001)]. Deshalb ist ein Ablösen der magnetischen Formgedächtnisschichten vom starren Substrat notwendig, um einen Aktoreffekt auf makroskopischer Skale zu erzielen. Dong [Dong, J. W. et al. J. Appl. Phys. 95 (5), 2593 (2004)] berichtet über Hinweise auf Längenänderungen durch MIR beim Messen einer freistehenden Brücke aus einer epitaktischen Ni-Mn-Ga Schicht im Magnetfeld. Jedoch wurde der Effekt nur deutlich unter Raumtemperatur beobachtet.
Mittels der so genannten Opferschicht-Technologie können (teilweise) freie Schichten, wie sie in Positionierungssystemen (US 6,251,298 B1, US 6,214,244 B1) oder Beschleunigungs- und Positionssensoren (JP 11103076 A1, JP 11220135 A1) benötigt werden, hergestellt werden. Diese Technologie erlaubt die Herstellung von ganz oder teilweise freistehenden Schichten ohne das Substrat selbst auflösen zu müssen. Die ganz oder teilweise freistehenden Schichten werden stattdessen durch selektives Entfernen der zwischen Substrat und Funktionsschicht eingebrachten Opferschicht hergestellt. Als Opferschichten können Si (A. Maciossek, u.a., Microelectronic Engineering, Vol. 27, 503-508, (1995)), poröses Si (T. E. Bell, u.a., J. Micromech. Microeng., Vol. 6, 361-369 (1996); US 2006 115 919 A1), Cu (S. D. Leith, u.a., J. Micromech. Microeng., Vol. 9, 97-104 (1999)), Mg (E. K. Kim, u.a. Thin Solid Films, Vol. 496, 653-657 (2006)) amorphe Materialien, wie SiO₂ (M. Lee, u.a., Thin Solid Films 447-448 (2004) 615-618), oder auch Polymere, wie das Polyimid (A. B. Frazier, u.a, J. Microelectromech. Sys. 6 (1997)) oder der wasserlösliche Polyvinylalkohol (PVA) verwendet werden. PVA als lösliches Substrat wurde u. a. von Ohtsuka et al. zur Herstellung freitragender Ni-Mn-Ga Schichten verwendet [Ohtsuka, M., et al: Mat. Sci. Eng. A 378 (1-2), 377 (2004)]. Diese Schichten weisen eine Dehnung von ca. 0,03 % basierend auf MIM auf. Jedoch waren hierzu sowohl ein nachträgliches Auslagern als auch ein Training notwendig.

Anwendungsrelevant ist die Erreichung einer hohen relativen Längenänderung, bei der es sich, im Gegensatz zur absoluten Längenänderung, um eine auf die Ausgangsdimensionen normierte Längenänderung handelt. Die relative Längenänderung wird häufig prozentual angegeben und ist von den Dimensionen des beweglichen magnetischen Formgedächtniselements unabhängig.

Nachteilig bei den Lösungen des Stands der Technik für magnetische Formgedächtnislegierungen ist, dass ein Magnetfeld erzeugt werden muss, für das aufwendige Spulensysteme und magnetische Flussführungen verwendet werden müssen. Dies behindert insbesondere die Integration in Mikrosysteme, da für die Herstellung von Mikrospulen viele Herstellungsschritte notwendig sind (Wurz, M. et al. IEEE Trans. Mag. 42(2006) 2468) .

Nachteilig ist zudem, dass bei nichtmagnetischen Formgedächtnislegierungen ein aufwendiges thermomechanisches Trainieren notwendig ist, um einen reversiblen Zweiwege Aktoreffekt zu erzielen. Insbesondere für integrierte Mikrosysteme erfordert dies einen üblicherweise nicht praktikablen Mehraufwand.

Aufgabe der vorliegenden Erfindung ist es, ein Bauelement aus einem ferromagnetischen Formgedächtnismaterial anzugeben, bei welchem eine deutlich größere relative Längenänderungen auftritt, sowie dessen Verwendung.

Diese Aufgabe wird durch die in den Ansprüchen angegebene Erfindung gelöst. Vorteilhafte Ausgestaltungen sind Gegenstand der Unteransprüche.

Das erfindungsgemäße Bauelement aus mindestens einem ferromagnetischen Formgedächtnis-Material, welches bei einem Temperaturzyklus einen martensitischen Phasenübergang und im martensitischen Zustand eine durch Variantenauswahl reduzierte magnetische Streufeldenergie aufweist, und welches ohne ein zusätzliches äußeres Magnetfeld anwendbar ist und bei dem die Variantenauswahl ohne ein thermo-mechanisches Training des Formgedächtnis-Effektes realisiert ist, wird hergestellt durch ein Verfahren, bei dem auf ein einkristallines oder biaxial texturiertes Substrat mindestens eine Opferschicht aufgebracht, auf die eine epitaktische oder texturierte Schicht aus einem ferromagnetischen Formgedächtnismaterial mit einer Schichtdicke von ≤ 50 µm aufgebracht wird, nachfolgend die Opferschicht teilweise entfernt wird, und während oder nach der Schichtaufbringung eine Strukturierung mindestens des ferromagnetischen Formgedächtnismaterials dahingehend realisiert wird, dass ein Aspektverhältnis erreicht wird, bei dem mindestens eine Länge um mindestens einen Faktor als 3 größer ist als die Dicke der Schicht oder der kürzesten Abmessung des Bauteils.

Vorteilhafterweise sind das ferromagnetische Formgedächtnismaterial Ni-Mn-Ga-, Fe-Pd-, Co-Ni-Ga-, Ni-Fe-Ga- und/oder Co-Fe-Ga -Basislegierungen, wobei bevorzugt bis zu 10 at.-% andere Legierungselemente vorhanden sind, und noch vorteilhafterweise bis zu 10 at.-% an W, Co, Mn und/oder Ir als Legierungselemente vorhanden sind.

Ebenfalls vorteilhafterweise weist durch die Entfernung der Opferschicht die strukturierte epitaktische ferromagnetische Formgedächtnismaterialschicht zu mindestens 50 % ihrer Fläche keine kraftschlüssige Verbindung zu dem Substrat oder einem anderen Material auf, wobei vorteilhafterweise das andere Material eine Opferschicht oder Elektroden sind, und auch vorteilhafterweise das andere Material eine geringere Dehnung als das ferromagnetische Formgedächtnismaterial besitzt.

Weiterhin vorteilhafterweise besteht im Wesentlichen keine kraftschlüssige Verbindung zwischen der strukturierten epitaktischen ferromagnetischen Formgedächtnismaterialschicht zu einem Substrat oder einem anderen Material, wobei vorteilhafterweise das andere Material eine Opferschicht oder Elektroden sind, und auch vorteilhafterweise das andere Material eine geringere Dehnung als das ferromagnetische Formgedächtnismaterial besitzt.

Und auch vorteilhafterweise ist ein epitaktisches oder biaxial texturiertes, ferromagnetisches Formgedächtnismaterial vorhanden.

Vorteilhaft ist es, wenn die Länge und/oder Breite der strukturierten Schicht aus dem ferromagnetischen Formgedächtnismaterial mindestens um den Faktor 3 bis 100 größer als die Dicke der Schicht ist.

Ebenfalls vorteilhaft ist es, wenn die Länge und/oder Breite der strukturierten Schicht eine Ausdehnung von maximal 1 mm aufweist.

Weiterhin vorteilhaft ist es, wenn das ferromagnetische Formgedächtnis-Material eine Curietemperatur oberhalb der martensitischen Phasenumwandlungstemperatur aufweist.

Und auch vorteilhaft ist es, wenn die Opferschicht aus Cr, NaCl, Rh, Cu, Au, Pt, Pd, Ta, W oder Ag besteht.

Von Vorteil ist es auch, wenn zwischen Substrat und Opferschicht und/oder zwischen Opferschicht und der Schicht aus dem epitaktischen ferromagnetischen Formgedächtnismaterial Pufferschichten oder weitere Schichten angeordnet sind.

Und auch von Vorteil ist es, wenn die Schichtdicke der epitaktischen ferromagnetischen Formgedächtnismaterialschicht ≤ 20 µm, noch vorteilhafter ≤ 1 µm beträgt.

Ebenfalls von Vorteil ist es, wenn in der ferromagnetischen Formgedächtnismaterialschicht im Mittel keine Großwinkelkorngrenzen in einem Volumen vorhanden sind, das durch den Querschnitt multipliziert mit dem minimalen Wert von Dicke oder Breite bestimmt ist.

Weiterhin von Vorteil ist es, wenn mindestens in der epitaktischen ferromagnetischen Formgedächtnismaterialschicht im Mittel weniger als ein nicht punktförmiger Defekt in einem Volumen vorhanden ist, das durch den Querschnitt multipliziert mit dem minimalen Wert von Dicke oder Breite bestimmt ist.

Vorteilhafterweise werden Ausgangsstoffe des ferromagnetischen Formgedächtnismaterials und Beschichtungsmedien eingesetzt, die Verunreinigungen von < 1 Vol.-%, noch vorteilhafterweise < 0,1 Vol.-% aufweisen.

Weiterhin vorteilhafterweise erfolgt die Strukturierung durch lithografische Verfahren mit Hilfe von Licht, Elektronen oder Röntgenstrahlen.

Ebenfalls vorteilhafterweise wird die Aufbringung der epitaktischen ferromagnetischen Formgedächtnismaterialschicht bei Temperaturen im Bereich von 0 - 800 °C durchgeführt.

Von Vorteil ist es auch, wenn die Aufbringung einer Schicht aus einer Ni-Mn-Ga-Basislegierung bei Temperaturen von 250 bis 500 °C durchgeführt ist.

Ebenfalls ist es von Vorteil, wenn die Aufbringung einer Fe-Pd-Basislegierung bei einer Temperatur unterhalb von 300° durchgeführt wird.

Und auch von Vorteil ist es, wenn das Bauelement aus zwei senkrecht zueinander stehenden Stegen oder Drähten aus einem ferromagnetischen Formgedächtnismaterial besteht, die Bewegungen in zwei unabhängigen Richtungen realisieren.

Erfindungsgemäß wird das erfindungsgemäße Bauteil als Mikroaktor oder als Mikrosensor verwendet.

Vorteilhafterweise wird das Bauteil als Linearaktor, Positionierungssystem, optisches Bauelement, y-x-Scanner oder in Stents verwendet.

Ebenfalls vorteilhafterweise wird das Bauteil als Positions-, Längen- oder Drucksensor verwendet.

Mit dem erfindungsgemäßen neuartigen Bauelement aus einem ferromagnetischen Formgedächtnismaterial liegt erstmals ein Bauelement vor, für dessen Anwendung weder ein Training, wie für konventionelle, nichtmagnetische Formgedächtnislegierungen zwingend notwendig, noch ein zusätzliches äußeres magnetisches Feld benötigt wird. Diese bisher zwingenden Erfordernisse der Lösungen nach dem Stand der Technik verhinderten insbesondere die Nutzung von Formgedächtnislegierungen in Mikrosystemen.

Daher wird mit der erfindungsgemäßen Lösung ein neues Wirkprinzip verwirklicht, indem Bauelemente aus mindestens teilweise freistehende ferromagnetische Formgedächtnismaterialien durch Temperaturänderung eine Dehnung der ferromagnetischen Formgedächtnismaterialien mit einem deutlich höheren Prozentsatz und sogar bis in den Bereich der theoretisch möglichen Längenänderungsbereiche zeigen. Hierfür ist eine mindestens teilweise Freistellung des erfindungsgemäßen Bauelementes notwendig, da sonst keine Längenänderung realisiert werden kann.

Dieses neue Wirkprinzip wird nachfolgend als "Streufeld Induzierte Mikrostruktur" (SFIM) bezeichnet und wird nachfolgend erläutert und nachgewiesen.

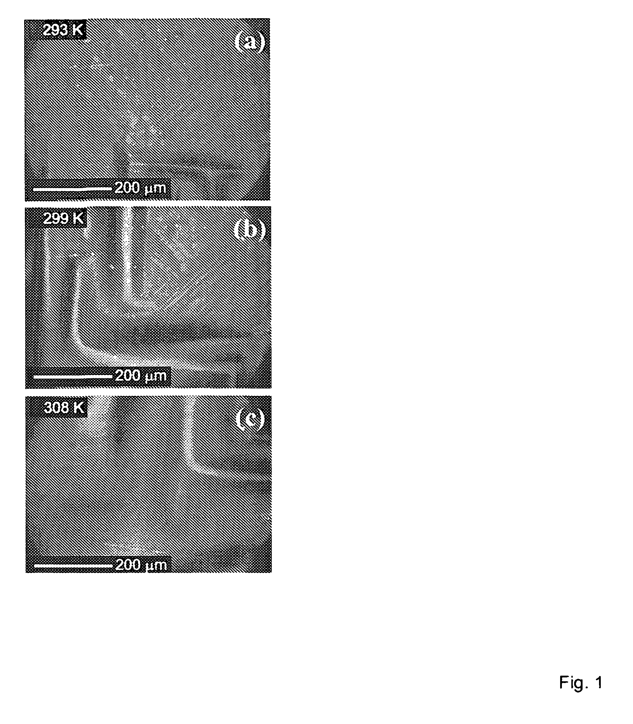

Die Expansion und Kontraktion durch SFIM kann direkt an einer mindestens teilweise freistehenden Schicht mit dem optischen Polarisationsmikroskop bei unterschiedlichen Temperaturen in-situ beobachtet werden. Eine Folge von drei exemplarischen Bildern ist in Fig. 1 a-c abgebildet. Ein erfindungsgemäßes ferromagnetisches Formgedächtnismaterial aus Ni-Mn-Ga wurde in einer Schicht auf eine (001)-orientiertes NaCl-Substrat, welches gleichzeitig als Opferschicht dient, deponiert. Dieses Verfahren wurde auch von Hakola et al. für die Herstellung polykristalliner Schichten genutzt [Hakola, A., et al: J. of Phys. 59, 122 (2007)]. Nach dem Auflösen des Substrates lag eine vollkommen freitragende Schicht aus Ni-Mn-Ga vor. Dieses Material liegt bei der Temperatur von 293 K in der Martensitphase vor. Die Varianten sind als parallele oder senkrechte Bänder sichtbar. Beim Aufheizen der Schicht verschwindet die verzwillingte Mikrostruktur nach und nach bis die kubische Austenitphase vollständig ausgebildet ist. Dabei wellt sich die Schicht aufgrund ihrer eigenen Ausdehnung. Um den Zwischenzustand der Schicht zu zeigen, ist eine Abbildung bei 299 K gezeigt. Bei 308 K ist der martensitische Phasenübergang abgeschlossen. Um wieder den martensitischen Zustand zu erreichen, muss die Schicht bis unter 289 K gekühlt werden, da auf dem Rückweg die thermische Hysterese des martensitischen Phasenübergangs überwunden werden muss. Das Zwillingsmuster ist nach Abkühlung ähnlich, jedoch nicht identisch zur Variantenverteilung zu Beginn des thermischen Zyklus.

Da bei der erfindungsgemäßen Lösung kein mechanisches Training notwendig ist und an dünnen freitragenden Schichten auch nicht mit üblichen Methoden möglich wäre, kann die real existierende Ausdehnung nicht dem konventionellen thermischen Zwei-Wege-Formgedächtniseffekt zugeschrieben werden. Darüber hinaus wurde kein Magnetfeld während des gesamten Zyklus angelegt, womit auch MIM ausgeschlossen ist.

Weitere Experimente bei konstanter Temperatur in der Martensitphase und bei äußeren Magnetfeldern bis zu 0.4 T, zeigten keine Veränderung der Mikrostruktur. Damit ist auch MIR als weitere Erklärung ausgeschlossen.

Die Beobachtung kann somit nicht den bekannten Effekten zugeordnet werden.

Daher wurden weitere Untersuchungen zum Nachweis des neuen Wirkungsprinzipes durchgeführt. Die Entstehung einer "Streufeldinduzierten Mikrostruktur" (SFIM) wurde mittels Röntgendiffraktometrie, Magnetometrie und Polarisationsmikroskopie beobachtet.

Durch röntgendiffraktometrische Untersuchungen konnte festgestellt werden, dass die Intensität des Austenit-Reflexes verringert ist, da der Volumenanteil des Austenits aufgrund einer nunmehr fehlenden äußeren mechanischen Spannung infolge der freistehenden Schicht geringer ist. Verglichen mit massiven, spannungsfreien Proben treten nicht alle Varianten mit derselben Häufigkeit auf, sondern es gibt eine deutliche Asymmetrie. Varianten, die mit ihrer c-Achse in Schichtebene orientiert sind haben eine deutlich höhere Häufigkeit. Dies erklärt die laterale Kontraktion der Schicht bei Übergang in die Martensitphase, denn die c-Achse ist kürzer als die a-Achse. Um diese Ungleichverteilung der Varianten zu erklären, müssen die magnetischen Eigenschaften der Schicht berücksichtigt werden.
Um den Volumenanteil der mit ihrer c-Achse in der Schichtebene liegenden Varianten und die magneto-kristalline Anisotropie zu bestimmen, wurden Magnetisierungskurven an der freistehenden Schicht im Martensit gemessen und mit der Kurve für Austenit verglichen. In der Austenitphase ist die Magnetisierungskurve geschlossen und zeigt nur eine geringe Koerzitivität, was gewöhnlich für Schichten mit einer geringen magneto-kristallinen Anisotropie ist. Beim Abkühlen der Schicht in die Martensitphase ändert sich deutlich die Form der Magnetisierungskurve und gleichzeitig steigt die Koerzitivität an.
In Übereinstimmung der mit Röntgendiffraktometrie gemessenen Varianten-Verteilung ergeben sich zwei deutlich unterschiedliche Anstiege der Magnetisierungskurve. Diese zwei Anstiege können den unterschiedlichen kristallografischen Orientierungen der Varianten zugeordnet werden.

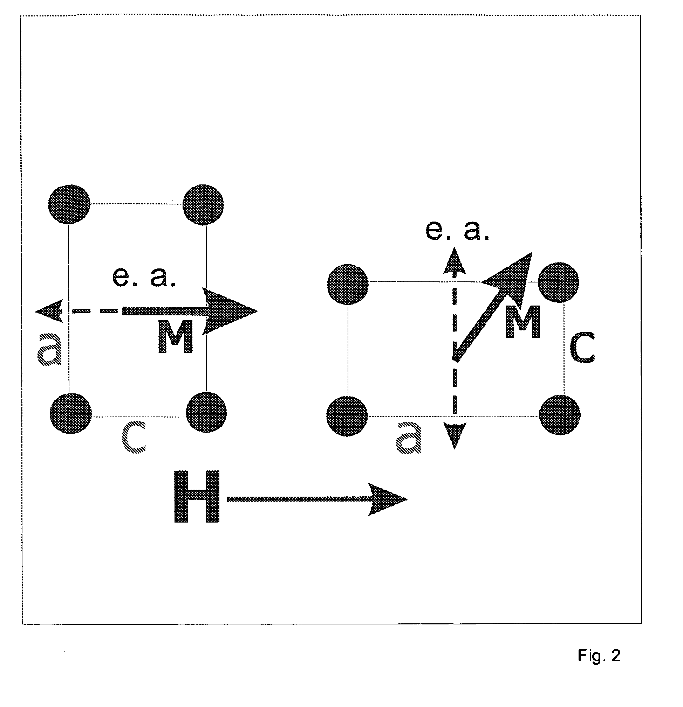

In Fig. 2 ist die Aufsicht auf die Schichtebene mit den zwei Hauptorientierungen der Varianten beider unterschiedlicher Orientierungen schematisch dargestellt. Die kurze c-Achse fällt mit der magnetisch leichten Achse (e. a..,gestrichelter Doppelpfeil) zusammen. Bei Anlegen des Magnetfelds H in Schichtebene wird die Magnetisierung des linken Variants in Feldrichtung geschalten, während der Variant auf der rechten Seite eine kontinuierliche Rotation der Magnetisierung in Richtung der magnetisch harten a-Achse zeigt. Der geringe Anteil der Varianten mit ihrer c-Achse senkrecht zur Schichtebene ist im Schema nicht dargestellt.
Die Superposition des Verhaltens der leichten und schweren Achse in der Magnetisierungskurve lässt sich für eine Abschätzung der Volumenanteile der unterschiedlich orientierten Varianten nutzen.
Der Anteil der Varianten mit leichter Achse in Feldrichtung wird durch Extrapolation der Magnetisierungskurve entlang der harten Richtung auf 0 T bestimmt. Es konnte festgestellt werden, dass fast alle Varianten mit ihrer leichten c-Achse in der Schichtebene liegen und in beide senkrechten äquivalenten Ebenenrichtungen gleichverteilt sind. Die Gleichverteilung in der Schichtebene wird durch die 4-zählige Symmetrie des Substrates erzeugt. Nur ein geringer Anteil der Varianten steht mit ihrer c-Achse senkrecht zur Schichtebene.
Um die bevorzugte Orientierung der Varianten mit ihrer leichten Achse in der Schichtebene zu erklären, muss eine Gesamtenergiebetrachtung durchgeführt werden. Durch die magneto-kristalline Anisotropie ist eine Ausrichtung der Magnetisierung in Richtung der leichten c-Achse bevorzugt. Varianten, die mit ihrer c-Achse senkrecht zur Schichtebene stehen erzeugen daher ein magnetisches Streufeld außerhalb der Schicht und dies kostet zusätzliche freie Energie. Ein zusätzlicher Energiebeitrag ist dagegen für Varianten mit ihrer leichten c-Achse in Schichtebene nicht notwendig. Die obere Grenze für die Streufeldenergie [ O'Handley, R. C. Modern Magnetic Materials (John Wiley & Sons, Inc, New York, 2000)] kann durch Betrachtung eines Einvariantenzustandes mit der c-Achse senkrecht zur Schichtebene im Eindomänenzustand bestimmt werden. Diese Energie damit gleich der Entmagnetisierungs-Energiedichte
Wird die Bildung von magnetischen Domänen mit Magnetisierungsrichtung senkrecht zur Schichtebene berücksichtigt [Hubert, A. & Schäfer, S. Magnetic Domains (Springer, Berlin, 1998), 306 ff.], so ergibt sich ein geringerer und dennoch bedeutender Gesamtenergiebeitrag, *e*ₜₒₜ = 0.5×10⁵ *J*/*m*³, für die zu Grunde liegende Schichtdicke von 0.5 µm. Eine Verringerung der Aktorgröße in Richtung Eindomänenteilchengröße vergrößert diese Energie [Hubert, A. & Schäfer, S. Magnetic Domains (Springer, Berlin, 1998), 306 ff.]. Dieses ist ein günstiges Skalierungsverhalten insbesondere für Nanoaktoren, die auch von dem günstigen Oberflächen- zu Volumen- Verhältnis profitieren, welches eine schnelle Kühlung ermöglicht.

Die erfindungsgemäßen Bauelemente aus magnetischen Formgedächtnismaterialien können ihre Varianten-Verteilung ändern um ihre Gesamtenergie zu verringern. Dies ist ein Freiheitsgrad den es in gewöhnlichen magnetischen Schichten nicht gibt.
Im Fall, dass keine Varianten mit ihrer c-Achse senkrecht zur Schichtebene existieren und die Magnetisierung in der Schichtebene liegt, ist der Beitrag der magnetischen Streufeld-Energie Null. Für diese Konfiguration kann die maximal mögliche Kontraktion der Schicht aus den unterschiedlichen Gitterabständen für Martensit und Austenit ermittelt werden. Als obere Grenze für die relative Längenänderung ergibt sich Δ*l*/*l*=1-1/2(*a_{M} +c_{M}*)/*a_{A}* =1.1%, ein deutlich größerer Wert als die Längenänderung, die man lediglich aus der Änderung des Volumens beim Übergang vom Austenit in den Martensit in Höhe von 0.2 % erhält.

Somit erlaubt der hier vorgestellte Ansatz mit freistehenden ferromagnetischen Formgedächtnismaterialien deutliche Vorteile gegenüber den bisher bekannten Ansätzen. Die Varianten mit ihrer leichten Achse in Schichtebene werden beim Übergang zur Martensitphase bevorzugt gebildet, sodass magnetische Streufeld-Energie vermieden werden kann. Daraus ergibt sich eine reversible Schicht-Kontraktion von bis zu 1.1 %, und dies, ohne dass ein zusätzliches äußeres Magnetfeld notwendig ist.
Beide ferroische Eigenschaften in den ferromagnetischen Formgedächtnismaterialien der erfindungsgemäßen Bauteile sind günstig für SFIM: In einem gewöhnlichen uniaxialen Ferromagnet gibt es keinen zusätzlichen Freiheitsgrad für die Reorientierung der magnetisch leichten Achse. In einer nicht-magnetischen martensitischen Schicht gibt es kein magnetisches Streufeld, das zur Vermeidung von Varianten mit einer senkrecht zur Schichtebene orientierten c-Achse führt. Zusätzlich ist die energetische Instabilität am martensitischen Phasenübergang günstig für SFIM, so kann hier die Varianten-Verteilung leichter selektiert werden als bei MIR.

Bei der erfindungsgemäßen Herstellung der Bauelemente ist zu beachten, dass die Aufbringung der ferromagnetischen Formgedächtnismaterialschicht bei unterschiedlichen Temperaturen in Abhängigkeit vom gewählten Material und den Depositionsbedingungen durchgeführt werden kann. Beispielsweise ist für Ni-Mn-Ga eine erfindungsgemäße Depositionstemperatur von mindestens 300°C günstig, da für dieses Material die Beweglichkeit der Atome ausreichend ist, um Defekte auszuheilen
Defekte wie z. B. Korngrenzen, Antiphasengrenzen und Ausscheidungen wirken sich ungünstig aus, da das Pinning von Zwillingsgrenzen deren Beweglichkeit deutlich einschränken kann. Hierdurch kann sich nicht mehr die energetisch günstigste Variantenorientierung einstellen, die insbesondere eine minimale Streufeldenergie besitzt. Die kritische Anzahl an Defekten kann folgendermaßen für eine typische Aktorgeometrie abgeschätzt werden, die beispielsweise aus einem Biegebalken oder mehreren Stegen besteht. Die Längenänderung des Aktorbauelementes erfolgt üblicherweise entlang ihrer längsten Abmessungen, die im folgenden Aktorrichtung genannt wird. Diese Betrachtung bezieht sich auf eine Geometrie, bei der die {001} Ebenen der austenitischen Elementarzelle senkrecht zu dieser Aktorrichtung orientiert sind. In dieser Geometrie erreicht man eine maximale Dehnung, da bei allen anderen Ausrichtungen nur die Projektion des maximalen Gitterkonstantenunterschiedes in Aktorrichtung mit dem Sinus des Winkels zwischen Aktorrichtung und benachbarter [001] Richtung beiträgt Zwillingsgrenzen sind {101}-Ebenen, d. h. sie liegen in einem Winkel von rund 45° zu der Aktorrichtung. Da eine Zwillingsgrenze eine Störung des idealen Kristallgitters darstellt, erfordert sie eine zusätzliche freie Energie. Deshalb werden sich Zwillingsgrenzen so ausrichten, dass sie eine minimale Fläche benötigen. Somit erstrecken sich Zwillingsgrenzen über eine charakteristische Länge entlang der Aktorrichtung, die durch das Minimum von Breite oder Schichtdicke bestimmt ist. Befindet sich ein als Pinningzentrum wirkender Defekt in diesem Volumen [charakteristische Länge (minimale Breite oder Dicke) mal Querschnitt], trägt dieser Volumenbruchteil des Steges nicht mehr wesentlich zur Ausdehnung bei. Punktförmige Defekte, wie z. B. Fehlbesetzungen in der chemischen Ordnung, wirken nicht als effizentes Pinningzentrum und müssen bei dieser Abschätzung nicht berücksichtigt werden.
Daher sollten sich in diesem Volumen insbesondere keine Korngrenzen befinden. Bei nachträglich wärmebehandelten und somit polykristallinen Schichten gemäß dem Stand der Technik wächst die Korngröße mit Temperatur und Zeit an, es wird jedoch häufig eine maximale Korngröße beobachtet, die in der gleichen Größenordnung wie die Schichtdicke liegt. Da Korngrenzen als effiziente Pinningzentren wirken, sind polykristallinen Schichten nicht für die Verwendung als Aktor geeignet. Erfindungsgemäß wird daher eine epitaktische Schicht verwendet. Bei epitaktischen Schichten wird die Orientierung der aufwachsenden Schicht durch das verwendet einkristalline Substrat und der ggf. hierauf aufwachsenden epitaktischen Pufferschichten bestimmt. Durch die hierdurch vorgegebene Orientierung der Elementarzellen der Schicht weisen epitaktische Schichten keine Großwinkelkorngrenzen auf. Durch die Verwendung eines Substrates mit geringem Unterschied der Gitterkonstanten und ausreichenden Depositionstemperaturen kann auch der Anteil an Kleinwinkelkorngrenzen stark reduziert werden.

Hinsichtlich der Defekte in der ferromagnetischen Formgedächtnismaterialschicht, wie z. B. Korngrenzen, Antiphasengrenzen und Ausscheidungen, ist zu sagen, dass erfindungsgemäß deren kritische Anzahl, die durch Verunreinigungen der Ausgangsstoffe des ferromagnetischen Formgedächtnismaterials und Beschichtungsmedien von maximal einem Volumenprozent eingebracht worden sind, nicht überschritten werden darf. Sonst können sich Zwillingsgrenzen nicht mehr bewegen und es kann sich nicht die Variantenorientierung einstellen, die eine ausreichend geringe Streufeldenergie realisiert.

Bezüglich der Depositionstemperatur für das Fe-Pd System ist eine Temperatur um die Raumtemperatur günstiger. In diesem chemisch ungeordneten System wird epitaktisches Wachstum schon bei Raumtemperatur erreicht. Eine Deposition bei höheren Temperaturen ist für dieses System ungünstiger, da es in diesem System zu einer Entmischung in eine Fe-reiche Fe(Pd) Phase mit kubisch raumzentrierter Struktur und L1₀ geordnetem FePd kommt.
Im Falle des Einsatzes einer FePd-Basis-Legierung als ferromagnetische Formgedächtnismaterialschicht ist der Einsatz einer Rhodium Schicht als zusätzliche Opferschicht günstig, da sie das epitaktische Wachstum von Cr auf Fe-Pd vermitteln kann.

Durch die Realisierung einer erfindungsgemäßen Geometrie des erfindungsgemäßen Bauteiles, bei dem nach der Strukturierung der epitaktischen ferromagnetischen Formgedächtnismaterialschicht die Länge und/oder Breite der Schicht mindestens um den Faktor 2 größer ist, als die Dicke der Schicht, die maximal ≤ 50 µm betragen soll, wird eine magnetische Formanisotropie realisiert.
Durch diese magnetische Formanisotropie wiederum wird die Ausrichtung der Magnetisierung entlang der jeweiligen Aktorrichtung bevorzugt. Hierdurch richtet sich im martensitischen Zustand die magnetisch leichte Achse, die im Fall von Ni-Mn-Ga mit der kristallographisch kürzeren Achse zusammenfällt, entlang der Aktorrichtung aus.
Um SFIM zu nutzen, sind keine komplexen magnetischen oder komplexe mechanische Bauelemente notwendig. Für einen reversiblen Aktorzyklus ist nur ein Temperaturzyklus notwendig. Die Temperaturerhöhung kann zum Beispiel erreicht werden, indem ein elektrischer Strom durch das Material geführt wird, oder das Material auf eine beheizbare Unterlage gelegt wird. Die Temperaturabsenkung kann über Wärmeleitung oder Wärmeabstrahlung an die Umgebung erfolgen.

Weiterhin ist im Gegensatz zum gewöhnlichen thermischen Zwei-Wege-Formgedächtniseffekt kein mechanisches Training notwendig. Dies ist die Schlüsselvoraussetzung für eine Anwendung der erfindungsgemäßen Lösung in integrierten Mikrosystemen und war bisher mit konventionellen unmagnetischen Formgedächtnislegierungen nicht möglich. Daher wird SFIM die weitere Miniaturisierung der Formgedächtnis-Aktoren bis hin zur Sub-Mikro-Skale erlauben, was ein viel einfacherer Weg zu Integration dieser Bauelemente ist.

Anwendungsmöglichkeiten könnten beispielsweise als Linearaktor sein, der als Funktion einen Laserstrahl abblenden kann. Oder es können Aktoren hergestellt werden, bei denen Bewegungen in mehr als eine Richtung möglich sind, so dass sich x-y Scanner realisieren lassen. Auch dreidimensionale Geometrien lassen sich realisieren. Es ist ebenfalls möglich, dass die erfindungsgemäßen Schichten des epitaktische oder texturierte ferromagnetischen Formgedächtnismaterials aufgerollt in Draht- oder Röhrenform eingesetzt werden können. Auch durch diese Formen sind die geometrisch notwendigen Bedingungen des erfindungsgemäßen Bauelementes gesichert. So basieren aktuell eingesetzte Stents üblicherweise auf Formgedächtnisdrähten. Auch diese können durch erfindungsgemäße Bauelemente aus ferromagnetischen Formgedächtnis-Drähten ersetzt werden und es werden deutlich größere Dehnungen auch ohne vorheriges Training erreicht. Durch eine spezielle Anordnung der Drähte können auch gezielte, nichtlineare Verformungen erreicht werden.
Ebenso lässt sich erfindungsgemäß ein vollständig integrierter Mikroaktor mit Dünnschichttechniken herstellen und eine weitere Verkleinerung des Aufbaus ist ohne weiteres möglich.
Das erfindungsgemäße Bauelement ist weiterhin vorteilhafterweise als rückstellender Mechanismus nutzbar, wodurch das Bauelement auch als Sensor einsetzbar ist. Detektiert werden kann die Position, Länge oder ein von außen einwirkender Druck, der zu einer Positionsverschiebung von Teilen des Bauelementes führt. Als Messgröße kann hier die elektrische Leitfähigkeit dienen oder magnetische Größen, wie z. B. die magnetische Permeabilität.

Nachfolgend wird die Erfindung an mehreren Ausführungsbeispielen näher erläutert.

Dabei zeigt:

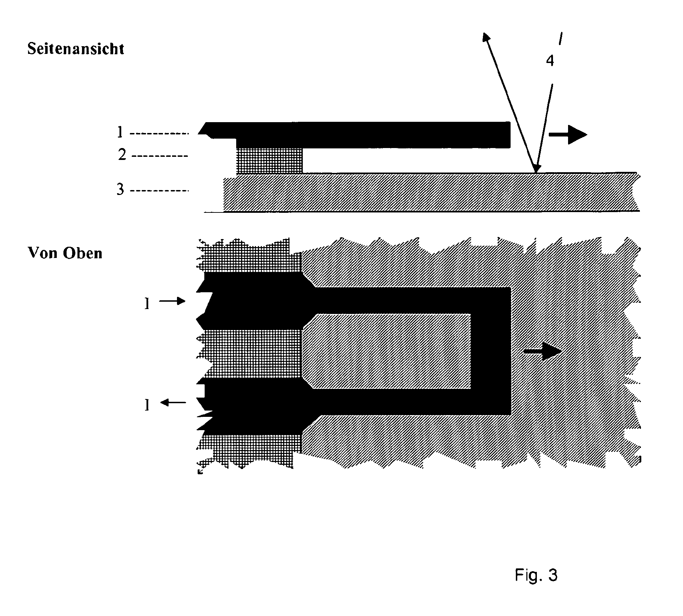

- Fig. 3: eine Seitenansicht und eine Ansicht von oben auf ein erfindungsgemäßes Bauelement
- Fig. 4: die Aufsicht auf einen schematisch dargestellten x-y Scanner

### Beispiel 1

Verwendet wird ein 4" Si-Substrat, bei dem durch Ätzen in Flusssäure die natürliche Oxidschicht entfernt wird. Die hierdurch entstandene wasserstoffterminierte Oberfläche ist bis zu 10 Minuten an Luft stabil, so dass das Substrat innerhalb dieser Zeit in die Schleuse der UHV-Depositionsanlage eingeschleust werden kann. Auf dieses Substrat wird eine Cr-Opferschicht mit 200 nm Dicke so aufgebracht, dass diese epitaktisch gewachsen ist. Auf diese Opferschicht wiederum wird epitaktisch eine Ni-Mn-Ga Schicht von 1 µm Dicke als aktives Material deponiert. Mit Photolithographie wird dann in einem Bauelementbereich von 50 x 50 µm die Ni-Mn-Ga-Schicht in zwei Stege von 50 µm Länge und 10 µm Breite strukturiert, die an einem Ende mit einem weiteren Steg von 10 µm Breite und 15 µm Länge verbunden, so dass später ein U-förmiger Aktor entstehen kann. Als nächster Schritt werden mit dem Photolack die Bereiche abgedeckt, bei denen die Opferschicht nicht entfernt werden soll. Beim darauf folgenden Entfernen der Opferschicht mittels einer Mischung aus Perchlorsäure (HClO₄), Ammoniumcernitrat(NH₄)₂[Ce(NO3)₆. und Wasser in einem Mischungsverhältnis von 10,9% : 4,25% : 84,85 werden die Stege unterätzt und ein freitragendes "U" entsteht, welches am offenen Ende noch mit der Opferschicht kraftschlüssig verbunden ist. Die offenen Enden des Aktors werden als Elektroden verwendet, so dass keine schwächende Verbindung aus unterschiedlichen Materialien auftritt. Vorteilhaft ist, wenn die Stromzuführungen breiter gestaltet werden, was den elektrischen Widerstand reduziert. Hierdurch wird verhindert, dass es in diesem Bereich zu einer Umwandlung in den Austenit kommt. Durch die offenen Enden des U-förmigen Aktors wird ein Strom geschickt, durch den der Aktor aufgeheizt wird und das Material sich so in den austenitischen Zustand umwandelt. Wie vorher beschrieben, ist der austenitische Zustand lateral ausgedehnter als der martensitische, d. h. bei ausreichendem Stromdurchfluss dehnt sich der Aktor in Richtung des "U" aus und blendet den Laserstrahl aus. Durch die hohe Oberfläche kühlt die Ni-Mn-Ga-Schicht nach Abschalten des Stromes wieder schnell ab und wandelt sich in den Martensit um. Ohne dass ein zusätzliches äußeres Magnetfeld (also ein weiteres Magnetfeld neben dem Erdmagnetfeld) wirkt, unterscheidet sich die Streufeldenergie für unterschiedliche Orientierung von Varianten. So haben Varianten mit einer senkrecht orientierten, magnetisch leichten c-Achse eine höhere Streufeldenergie als Varianten, bei denen die c-Achse in der Schichtebene liegt. Daher nimmt der Anteil der senkrecht orientierten c-Varianten ab. Da die c-Achse in Ni-Mn-Ga die kürzeste Achse ist, führt dieses zu einer Kontraktion. Im Gegensatz zu konventionellen, unmagnetischen Formgedächtnislegierungen ist kein Training notwendig, d. h. es muss nicht durch äußere mechanische Kräfte eine bevorzugte Variantenverteilung eingestellt werden. Durch die Kontraktion des "U" wird der Laserstrahl wieder freigegeben und der Aktorprozess kann wiederholt werden.

Der Vorteil dieses Aufbaus liegt vor allem in den wenigen Bauelementen und dass er mit monolitischer Technologie hergestellt werden kann. So sind nur zwei Schichtmaterialien und zwei Strukturierungsschritte notwendig. Das Heizen mit elektrischem Strom erlaubt eine einfache Integration und Steuerung mit konventioneller Mikrosystemtechnik. Durch die große relative Dehnung des Effektes wird eine absolute Längenänderung von 0,5 µm erreicht, so dass sich eine Vielzahl von Systemen auf einem Chip realisieren lassen.

### Beispiel 2

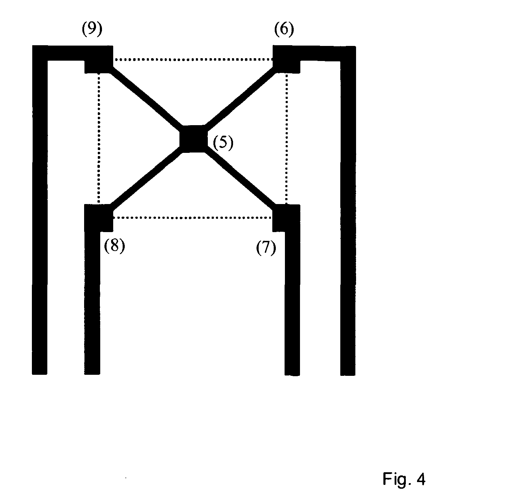

Als ein weiteres Bauelement ist ein x-y Scanner als Mikroaktor dargestellt (Fig. 4). Der Scannkopf 5 ist hier mit 4 Stegen an den Befestigungspunkten 6 bis 9 verbunden. Diese wiederum sind über Leiterbahnen miteinander verbunden, die es erlauben, diese Stege durch Anlegen eines Stromes zu Heizen.
Zur Herstellung dieses x-y-Scanners wird ein GaAs-Substrat verwendet, Auf dieses Substrat wird mittels Aufdampfen eine 200 nm dicke NaCl-Schicht bei 120°C abgeschieden, die später als Opferschicht dient. Als nächster Schritt wird bei einer Substrattemperatur von 300°C als ferromagnetische Formgedächtnismaterialschicht eine 2 µm dicke Ni-Mn-Ga-Schicht mittels Sputterdeposition abgeschieden, die aufgrund des geringen Gitterkonstantenunterschiedes zu NaCl auch epitaktisch aufwächst. Die Zusammensetzung des Sputtertargets wird so gewählt, dass die Zusammensetzung der ferromagnetischen Formgedächtnismaterialschicht Ni₅₀Mn₃₀Ga₂₀ ist und mögliche Änderungen der Zusammensetzung durch Abdampfen und/oder durch nichtstöchiometrischen Transfer vom Target auf das Substrat ausgeglichen werden. Diese Schichtzusammensetzung ist bei Raumtemperatur sowohl ferromagnetisch als auch martensitisch.

Für die Wahl der Depositionstemperatur war entscheidend, dass diese Temperatur ausreichend ist, um in Ni-Mn-Ga die L2₁-Ordnung einzustellen, und dass diese Depositionstemperatur deutlich niedriger ist als die Temperaturen, die bei einem zweistufigen Prozess gemäß dem Stand der Technik notwendig sind. Bei dem zweistufigen Prozess nach dem Stand der Technik wird bei Raumtemperatur abgeschieden und anschließend eine Wärmebehandlung zur Ordnungseinstellung oberhalb von 600°C durchgeführt. Bei einer Abscheidung bei Raumtemperatur ist die Ni-Mn-Ga-Legierung nicht chemisch geordnet und weist eine sehr kleine Kristallitgröße auf. Für diese Schichten ist eine Wärmebehandlung bei deutlich höheren Temperaturen notwendig, da sich im Volumen erst Leerstellen bilden müssen, die dann die notwendige Diffusion ermöglichen.
Wird, wie erfindungsgemäß, ein einstufiger Prozess realisiert, d. h. die Deposition auf einem geheizten Substrat, erlaubt die deutlich schnellere Oberflächendiffusion eine Ordnungseinstellung schon ab 250°C. Nach oben ist die Herstellungstemperatur automatisch durch die Diffusion von Ga und As limitiert, das zu ungünstigen Ausscheidungen in der Ni-Mn-Ga Schicht und damit zu Verunreinigungen und Defektbildungen führt.

Nach der Schichtabscheidung wird mit üblichen lithographischen Methoden die in Fig. 4 mit durchgezogenen Linien dargestellte Struktur in der Ni-Mn-Ga-Schicht hergestellt (Strukturierung). Als nächster Schritt wird die Schicht wiederum mit Photolack bedeckt und nur das gestrichelt dargestellte Quadrat belichtet und in diesem Bereich der Photolack entfernt. Als nächster Schritt wird hier die NaCl-Schicht mit Wasser selektiv geätzt. Hierbei wird die Ätzzeit so lange gewählt, dass alle Stege und der zentrale Scanner 5 unterätzt werden. Hierdurch sind das Bauelement freitragend und kann sich unabhängig vom Substrat bewegen. Die Geometrie ist so gewählt, dass bei einer Stegbreite von 2 µm die Steglänge mit 10 µm um den Faktor 5 größer ist, als die Dicke der Schicht.

Zur Bewegung des Scannerkopfes 5 wird zwischen den Befestigungspunkten 6 und 7 eine Spannung anlegt. Durch den ohmschen Widerstand und den daraus folgenden Stromfluss heizen sich die Stege auf. Wird dadurch die Austenit-Finishtemperatur überschritten, so wandelt sich das Material in Austenit mit der kubischen Struktur um und die Stege längen sich. Hierdurch bewegt sich der Scannerkopf 5 aus seiner bisherigen Position heraus nach links. Andere Bewegungsrichtungen des Scannerkopfes 5 oder beliebige Kombinationen dieser Richtungen lassen sich durch die Auswahl des Stromflusses bezüglich Richtung und Höhe erreichen. Wird der Stromfluss unterbrochen, kühlt das Material ab und unterhalb der Martensit- Finishtemperatur zieht sich das Material wieder zusammen und bewegt den Scannerkopf 5 wieder zurück auf die Mittelposition.

Die mit der martensitischen Umwandlung verbundene Änderung des elektrischen Widerstandes kann wiederum zur Bestimmung der aktuellen Position des Scannerkopfes 5 verwendet werden. Somit lässt sich der gleiche Aufbau auch als Positionsdetektor verwenden. Sinnvollerweise wird hierbei eine deutlich geringere Spannung verwendet, so dass ein Aufheizen der Stege vermieden wird.

Der wesentliche Vorteil dieses x-y-Scanners im Gegensatz zu konventionellen Lösungen ist der sehr geringe Anteil an Bauelementen und Verfahrenschritten. So werden nur zwei Schichten und zwei lithographische Schritte benötigt. Insbesondere wird kein aufwändiger Transfer von einem Bauteil auf ein anderes Substrat benötigt. Durch die hohe, metallische Leitfähigkeit von Ni-Mn-Ga reichen im Gegensatz zu piezokeramischen Mikroaktoren geringe elektrische Spannungen von unter 5 V aus. Für eine Integration in mobile Systeme ist dieses von Vorteil, da insbesondere eine Integration von elektronischen und mechanischen Systemen auf einem Chip möglich wird.

### Bezugszeichenliste

- 1: Magnetische Formgedächnismaterialschicht
- 2: Opferschicht
- 3: Substrat
- 4: Laserstrahl
- 5: Scannkopf
- 6-9: Befestigungspunkte

## Patentansprüche

1. Bauelement aus mindestens einem ferromagnetischen Formgedächtnis-Material, welches bei einem Temperaturzyklus einen martensitischen Phasenübergang und im martensitischen Zustand eine durch Variantenauswahl reduzierte magnetische Streufeldenergie aufweist, und welches ohne ein zusätzliches äußeres Magnetfeld anwendbar ist und bei dem die Variantenauswahl ohne ein thermo-mechanisches Training des Formgedächtnis-Effektes realisiert ist, hergestellt durch ein Verfahren, bei dem auf ein einkristallines oder biaxial texturiertes Substrat mindestens eine Opferschicht aufgebracht wird, auf die eine epitaktische oder texturierte Schicht aus einem ferromagnetischen Formgedächtnismaterial mit einer Schichtdicke von ≤ 50 µm aufgebracht wird, nachfolgend die Opferschicht teilweise entfernt wird, und während oder nach der Schichtaufbringung eine Strukturierung mindestens des ferromagnetischen Formgedächtnismaterials dahingehend realisiert wird, dass ein Aspektverhältnis erreicht wird, bei dem mindestens eine Länge um mindestens einen Faktor als 3 größer ist als die Dicke der Schicht oder der kürzesten Abmessung des Bauteils.

2. Bauelement nach Anspruch 1, bei dem das ferromagnetische Formgedächtnismaterial Ni-Mn-Ga-, Fe-Pd-, Co-Ni-Ga-, Ni-Fe-Ga- und/oder Co-Fe-Ga-Basislegierungen sind, wobei vorteilhafterweise bis zu 10 at.-% andere Legierungselemente vorhanden sind, und diese bis zu 10 at.-% anderen Legierungselemente vorteilhafterweise W, Co, Mn und/oder Ir sind.

3. Bauelement nach Anspruch 1, bei dem durch die Entfernung der Opferschicht die strukturierte epitaktische ferromagnetische Formgedächtnismaterialschicht zu mindestens 50 % ihrer Fläche keine kraftschlüssige Verbindung zu dem Substrat oder einem anderen Material aufweist, oder bei dem im Wesentlichen keine kraftschlüssige Verbindung zwischen der strukturierten epitaktischen ferromagnetischen Formgedächtnismaterialschicht zu einem Substrat oder einem anderen Material besteht, wobei vorteilhafterweise das andere Material eine Opferschicht oder Elektroden sind, oder das andere Material eine geringere Dehnung als das ferromagnetische Formgedächtnismaterial besitzt

4. Bauelement nach Anspruch 1, bei dem ein epitaktisches oder biaxial texturiertes, ferromagnetisches Formgedächtnismaterial vorhanden ist, und/oder das ferromagnetische Formgedächtnismaterial weist eine Curietemperatur oberhalb der martensitischen Phasenumwandlungstemperatur auf.

5. Bauelement nach Anspruch 1, bei dem die Länge und/oder Breite der strukturierten Schicht aus dem ferromagnetischen Formgedächtnismaterial mindestens um den Faktor 3 bis 100 größer ist als die Dicke der Schicht, und/oder die Länge und/oder Breite der strukturierten Schicht eine Ausdehnung von maximal 1 mm aufweist.

6. Bauelement nach Anspruch 1, bei dem die Opferschicht aus Cr, NaCl, Rh, Cu, Au, Pt, Pd, Ta, W oder Ag besteht.

7. Bauelement nach Anspruch 1, bei dem zwischen Substrat und Opferschicht und/oder zwischen Opferschicht und der Schicht aus dem epitaktischen ferromagnetischen Formgedächtnismaterial Pufferschichten oder weitere Schichten angeordnet sind.

8. Bauelement nach Anspruch 1, bei dem die Schichtdicke der epitaktischen ferromagnetischen Formgedächtnismaterialschicht ≤ 20 µm, noch vorteilhafter ≤ 1 µm beträgt.

9. Bauelement nach Anspruch 1, bei dem in der ferromagnetischen Formgedächtnismaterialschicht im Mittel keine Großwinkelkorngrenzen in einem Volumen vorhanden sind, das durch den Querschnitt multipliziert mit dem minimalen Wert von Dicke oder Breite bestimmt ist.

10. Bauelement nach Anspruch 1, bei dem mindestens in der epitaktischen ferromagnetischen Formgedächtnismaterialschicht im Mittel weniger als ein nicht punktförmiger Defekt in einem Volumen vorhanden ist, das durch den Querschnitt multipliziert mit dem minimalen Wert von Dicke oder Breite bestimmt ist.

11. Bauelement nach Anspruch 1, bei dem Ausgangsstoffe des ferromagnetischen Formgedächtnismaterials und Beschichtungsmedien eingesetzt werden, die Verunreinigungen von < 1 Vol.%, vorteilhafterweise < 0,1 Vol.-%, aufweisen.

12. Bauelement nach Anspruch 1, bei dem die Strukturierung durch lithografische Verfahren mit Hilfe von Licht, Elektronen oder Röntgenstrahlen erfolgt ist.

13. Bauelement nach Anspruch 1, bei dem die Aufbringung der epitaktischen ferromagnetischen Formgedächtnismaterialschicht bei Temperaturen im Bereich von 0 - 800 °C durchgeführt ist, wobei vorteilhafterweise die Aufbringung einer Schicht aus einer Ni-Mn-Ga-Basislegierung bei Temperaturen von 250 bis 500 °C durchgeführt ist, und/oder die Aufbringung einer Fe-Pd-Basislegierung bei einer Temperatur unterhalb von 300° durchgeführt ist.

14. Bauelement nach Anspruch 1, bei dem das Bauelement aus zwei senkrecht zueinander stehenden Stegen oder Drähten aus einem ferromagnetischen Formgedächtnismaterial besteht, die Bewegungen in zwei unabhängigen Richtungen realisieren.

15. Verwendung eines Bauelementes nach mindestens einem der Ansprüche 1 bis 14 als Mikroaktor, vorteilhafterweise als Linearaktor, Positionierungssystem, optisches Bauelement, y-x-Scanner oder in Stents, oder als Mikrosensor, vorteilhafterweise als Positions-, Längen- oder Drucksensor.

## Claims

1. Construction element made of , at least one ferromagnetic shape memory material, which during a thermal cycle has a martensitic phase transition and in the martensitic state has a magnetic stray field energy reduced by variant selection, and which can be used without an additional external magnetic field and with which the variant selection is realized without thermal mechanical training of the shape memory effect, produced by a method in which at least one sacrificial layer is applied to a monocrystalline or biaxially textured substrate, on top of which an epitaxial or textured layer of a ferromagnetic shape memory material with a layer thickness of ≤ 50 µm is applied, and subsequently the sacrificial layer is at least partially removed, and during or after the application of the layer a structuring, at least of the ferromagnetic shape memory material, is realized so as to achieve an aspect ratio with which at least one length is greater than the thickness of the layer or the shortest dimension of the construction element by at least a factor of 3.

2. Construction element according to Claim 1, in which the ferromagnetic shape memory material comprises Ni-Mn-Ga, Fe-Pd, Co-Ni-Ga, Ni-Fe-Ga and/or Co-Fe-Ga base alloys, other alloying elements advantageously being present up to 10 atomic %, and these up to 10 atomic % of other alloying elements advantageously being W, Co, Mn and/or Ir.

3. Construction element according to Claim 1, in which the removal of the sacrificial layer has the effect that the structured layer of epitaxial ferromagnetic shape memory material has over at least 50% of its area no non-positive connection with the substrate or other material, or in which there is substantially no non-positive connection between the structured layer of epitaxial ferromagnetic shape memory material and a substrate or other material, the other material advantageously being a sacrificial layer or electrodes, or the other material having a smaller elongation than the ferromagnetic shape memory material.

4. Construction element according to Claim 1, in which an epitaxial or biaxially textured, ferromagnetic shape memory material is present, and/or the ferromagnetic shape memory material has a Curie temperature above the martensitic phase transition temperature.

5. Construction element according to Claim 1, in which the length and/or width of the structured layer of the ferromagnetic shape memory material is greater than the thickness of the layer by at least a factor of 3 to 100, and/or the length and/or width of the structured layer has an extent of a maximum of 1 mm.

6. Construction element according to Claim 1, in which the sacrificial layer consists of Cr, NaCl, Rh, Cu, Au, Pt, Pd, Ta, W or Ag.

7. Construction element according to Claim 1, in which buffer layers or further layers are arranged between the substrate and the sacrificial layer and/or between the sacrificial layer and the layer of the epitaxial ferromagnetic shape memory material.

8. Construction element according to Claim 1, in which the layer thickness of the layer of epitaxial shape memory material is ≤ 20 µm, even more advantageously ≤ 1 µm.

9. Construction element according to Claim 1, in which there are on average in the layer of ferromagnetic shape memory material no high-angle grain boundaries in a volume that is determined by the cross section multiplied by the minimum value of thickness or width.

10. Construction element according to Claim 1, in which there is on average at least in the layer of ferromagnetic shape memory material less than one non-pointlike defect in a volume that is determined by the cross section multiplied by the minimum value of thickness or width.

11. Construction element according to Claim 1, in which starting materials of the ferromagnetic shape memory material and coating media that have impurities of < 1% by volume, advantageously < 0.1% by volume, are used.

12. Construction element according to Claim 1, in which the structuring is performed by lithographic methods with the aid of light, electrons or x-rays.

13. Construction element according to Claim 1, in which the application of the layer of an epitaxial ferromagnetic shape memory material is carried out at temperatures in the range of 0 - 800°C, the application of a layer of an Ni-Mn-Ga base alloy advantageously being carried out at temperatures of 250 to 500°C, and/or the application of an Fe-Pd base alloy being carried out at a temperature below 300°C.

14. Construction element according to Claim 1, in which the construction element consists of two webs or wires of a ferromagnetic shape memory material that are perpendicular to one another and realize movements in two independent directions.

15. Use of a construction element according to at least one of Claims 1 to 14 as a micro-actuator, advantageously as a linear actuator, positioning system, optical component, y-x scanner or in stents, or as a micro-sensor, advantageously as a position, length or pressure sensor.

## Revendications

1. Composant en au moins un matériau ferromagnétique à mémoire de forme, qui présente lors d'un cycle de température une transformation de phase martensitique et à l'état martensitique une énergie de champ de dispersion magnétique réduite par sélection de variantes, et qui est applicable sans champ magnétique extérieur additionnel, et dans lequel la sélection de variantes est réalisée sans entraînement thermomécanique de l'effet de mémoire de forme, fabriqué par un procédé dans lequel on dépose au moins une couche sacrificielle sur un substrat monocristallin ou à texture biaxiale, sur laquelle on dépose une couche épitaxiale ou texturée en un matériau ferromagnétique à mémoire de forme avec une épaisseur de couche de ≤ 50 µm, on enlève ensuite partiellement la couche sacrificielle et, pendant ou après le dépôt des couches, on réalise une structuration au moins du matériau ferromagnétique à mémoire de forme en vue d'obtenir un rapport de forme dans lequel au moins une longueur est plus grande d'au moins un facteur de plus de 3 que l'épaisseur de la couche ou de la plus courte dimension du composant.

2. Composant selon la revendication 1, dans lequel le matériau ferromagnétique à mémoire de forme est un alliage à base de Ni-Mn-Ga, Fe-Pd, Co-Ni-Ga, Ni-Fe-Ga et/ou Co-Fe-Ga, dans lequel il se trouve avantageusement jusqu'à 10 % atomiques d'autres éléments d'alliage, et ces autres éléments d'alliage présents jusqu'à 10 % atomiques sont avantageusement W, Co, Mn et/ou Ir.

3. Composant selon la revendication 1, dans lequel, du fait de l'enlèvement de la couche sacrificielle, la couche épitaxiale structurée de matériau ferromagnétique à mémoire de forme ne présente sur jusqu'au moins 50 % de sa surface aucune liaison d'adhérence avec le substrat ou avec un autre matériau, ou dans lequel il n'existe essentiellement aucune liaison par adhérence entre la couche épitaxiale structurée de matériau ferromagnétique à mémoire de forme et le substrat ou un autre matériau, dans lequel l'autre matériau est avantageusement une couche sacrificielle ou des électrodes, ou l'autre matériau présente un allongement plus faible que le matériau ferromagnétique à mémoire de forme.

4. Composant selon la revendication 1, dans lequel il se trouve un matériau ferromagnétique à mémoire de forme épitaxial ou à texture biaxiale, et/ou le matériau ferromagnétique à mémoire de forme présente une température de Curie supérieure à la température de transformation de phase martensitique.

5. Composant selon la revendication 1, dans lequel la longueur et/ou la largeur de la couche structurée en matériau ferromagnétique à mémoire de forme est plus grande d'au moins un facteur 3 à 100 que l'épaisseur de la couche, et/ou la longueur et/ou la largeur de la couche structurée présente une extension de 1 mm au maximum.

6. Composant selon la revendication 1, dans lequel la couche sacrificielle se compose de Cr, NaCl, Rh, Cu, Au, Pt, Pd, Ta, W ou Ag.

7. Composant selon la revendication 1, dans lequel des couches tampons ou d'autres couches sont disposées entre le substrat et la couche sacrificielle et/ou entre la couche sacrificielle et le matériau ferromagnétique à mémoire de forme épitaxial.

8. Composant selon la revendication 1, dans lequel l'épaisseur de couche de la couche épitaxiale de matériau ferromagnétique à mémoire de forme est ≤ 20 µm, plus avantageusement encore ≤ 1 µm.

9. Composant selon la revendication 1, dans lequel il ne se trouve dans la couche de matériau ferromagnétique à mémoire de forme en moyenne pas de joints de grains aux grands angles dans un volume qui est déterminé par la section transversale multipliée par la valeur minimale de l'épaisseur ou de la largeur.

10. Composant selon la revendication 1, dans lequel il se trouve, au moins dans la couche épitaxiale de matériau ferromagnétique à mémoire de forme, en moyenne moins de un défaut non ponctuel dans un volume, qui est déterminé par la section transversale multipliée par la valeur minimale de l'épaisseur ou de la largeur.

11. Composant selon la revendication 1, dans lequel on utilise des matières premières du matériau ferromagnétique à mémoire de forme et des agents de revêtement qui présentent des impuretés de < 1 % en volume, avantageusement < 0,1 % en volume.

12. Composant selon la revendication 1, dans lequel la structuration est effectuée par des procédés lithographiques à l'aide de la lumière, d'électrons ou de rayonnements X.

13. Composant selon la revendication 1, dans lequel le dépôt de la couche épitaxiale en matériau ferromagnétique à mémoire de forme est effectué à des températures comprises dans la plage de 0 à 800°C, dans lequel avantageusement le dépôt d'une couche en un alliage à base Ni-Mn-Ga est effectué à des températures de 250 à 500°C et/ou le dépôt d'un alliage à base Fe-Pd est effectué à une température inférieure à 300°C.

14. Composant selon la revendication 1, dans lequel le composant se compose de deux âmes ou fils en un matériau ferromagnétique à mémoire de forme perpendiculaires l'un à l'autre, qui réalisent des mouvements dans deux directions indépendantes.

15. Utilisation d'un composant selon au moins une des revendications 1 à 14 comme micro-actionneur, avantageusement comme actionneur linéaire, système de positionnement, composant optique, scanneur x-y ou dans des stents, ou comme micro-capteur, avantageusement comme capteur de position, de longueur ou de pression.
